# EUROPÄISCHE PATENTANMELDUNG

(11) **EP 1 124 264 A2**
(43) Veröffentlichungstag der Anmeldung: **16.08.2001**
(21) Anmeldenummer: 01102970.9
(22) Anmeldetag: 08.02.2001
(51) Int. Cl.: H01L 31/18

(54) **Verfahren zur Herstellung von leitfähigen transparenten Strukturen sowie Verwendung von transparenten, leitfähigen Oxidschichten zur Strukturierung von leitfähigen, transparenten Bereichen**

(30) Priorität: 08.02.2000 DE 10005330
(71) Anmelder: FRAUNHOFER-GESELLSCHAFT ZUR FÖRDERUNG DER ANGEWANDTEN FORSCHUNG E.V., 80636 München (DE)
(72) Erfinder: Klages, Claus-Peter Dr., 38102 Braunschweig (DE); Neumann, Frank, 38100 Braunschweig (DE); Matthée, Thorsten Dr., 38527 Meine (DE); Szyszka, Bernd Dr., 38114 Braunschweig (DE)
(74) Vertreter: Einsel, Martin

(57) **Zusammenfassung**

Die vorliegende Erfindung betrifft ein Verfahren zur elektrischen und optischen Strukturierung von Substratmaterialien unter Einwirkung von Laserstrahlung sowie die Verwendung von transparenten, leitfähigen Oxidschichten und titan- und niobhaltigen Schichten zur Strukturierung von leitfähigen, transparenten Bereichen unter Ausbildung von beispielsweise Leiterbahnen, leitfähigen Flächen, optisch transparenten Fasern und Fenstern auf transparenten Substraten.

## Beschreibung

Die vorliegende Erfindung betrifft ein Verfahren zur Herstellung von leitfähigen transparenten Strukturen unter Lasereinwirkung sowie die Verwendung von transparenten, leitfähigen Oxidschichten und metallhaltigen Schichtsystemen zur Strukturierung von leitfähigen transparenten Bereichen mittels Lasereinwirkung.

Die Herstellung von optischen oder elektronischen Strukturen für zum Beispiel elektronische und optoelektronische Anwendungen, wie hochauflösende Gitter oder elektrischen Schaltelementen mit entsprechenden Leiterbahnen, erfordert bisher einen aufwendigen Arbeitsprozess mit zahlreichen Teilschritten, die die Maskenherstellung, das Beschichten, Belacken, Entwickeln und Ätzen beinhalten.

Hierzu müssen die verwendeten Substrate in komplizierten Arbeitsgängen zum Teil mehrfach beschichtet und mit einem fotosensitiven Lack überzogen werden. Anschließend muss eine zuvor strukturierte oder bedruckte und mit den zur Lithografie benötigten Informationen versehene Maske auf den vorstehend vorbereiteten Substraten ausgerichtet und feinjustiert werden. In einem weiteren Schritt werden nun auf den mit Fotolack beschichteten lichtempfindlichen Schichten die gewünschten Strukturen hineinbelichtet, worauf sich ein Entwicklungsschritt dieser Strukturen sowie das physikalische oder chemische Ätzen der Strukturen anschließen.
Je nach Anwendungszweck der herzustellenden Struktur werden mehrere Fotoschritte benötigt. Beispielsweise sind für die Herstellung einfacher Chips drei bis sechs solcher Fotoschritte und für die Herstellung eines Pentiumprozessors bereits zwanzig und mehr Fotoschritte erforderlich.

Derart aufwendige Verfahren sind mit erheblichen Kosten verbunden. Mit Zunahme der erforderlichen Arbeitsschritte steigen nicht nur die Kosten sondern auch der Materialverbrauch zum Beispiel für den Lack, die Masken, Entwickler- und Ätzbäder.

Weiter ist von Nachteil, dass die einzusetzenden Materialien auf das jeweils konkret angewendete Verfahren abgestimmt werden muss. Beispielsweise ist der Lack in Abhängigkeit des konkret eingesetzten Verfahrens auszuwählen. So muss der verwendete Lack auf das anzuwendende Ätzverfahren (Nass-, beziehungsweise Trockenätzen) und das zu ätzende Material abgestimmt werden.

Darüber hinaus stellt das vorstehend beschriebene Verfahren extrem hohe Anforderungen an die Reinraumbedingungen, da jedes Staubkorn einen Fehler produzieren kann und die Produktion von fehlerhaften Strukturen insbesondere in Hinblick auf die hohen Kosten, die mit dem Herstellungsprozess verbunden sind, vermieden werden sollen.

Ein weiteres Problem bereitet die Feinjustierung der Lithografiemasken insbesondere bei der exakten Ausrichtung von extrem kleinen Strukturen von nur wenigen Mikrometern. Das Belichten hochauflösender dreidimensionaler Strukturen ist damit so gut wie unmöglich und stellt bis heute das größte zu lösende Problem von derartigen Lithografieprozessen dar.

Es bestand daher ein großes Bedürfnis nach einem vereinfachten Verfahren zur Herstellung von optischen oder elektronischen Strukturen, mit dem auch extrem hochaufgelöste dreidimensionale Strukturen auf einfache Art und Weise kostengünstig hergestellt werden können.

Anlässlich einer Konferenz zum Thema Mikromaterialien vom 16. bis 18. April 1997 in Berlin, Deutschland wurde ein Verfahren zur Umwandlung von nicht leitfähigem Aluminiumoxid oder Aluminiumnitrid in das entsprechende leitfähige Material unter Einwirkung von Laserlicht vorgestellt (B. Stolz et al, "Surface modification of ceramics with laserradiation" Seiten 790 bis 794 in "Proceedings, International Confernece and Exhibition, Micromaterials, Micro-Mat -97). Gemäß dem dort beschriebenen Verfahren wird Laserlicht ausgewählter Laserlichtquellen auf ein Substrat aus Aluminiumnitrid oder Aluminiumoxid einwirken gelassen, wobei auf der Substratoberfläche durch den Laserbeschuss eine Materialumwandlung erfolgt, so dass der umgewandelte Bereich eine hohe Leitfähigkeit im Gegensatz zu den isolierenden Substratmaterialien aufweist. Diese hohe Leitfähigkeit wird auf die Ausbildung von im Wesentlichen aluminiumhaltigen, also metallischen, Phasen in dem keramischen Ausgangsmaterial zurückgeführt. Es wird vorgeschlagen, dieses Verfahren zur Herstellung von leitfähigen Strukturen auf einem Substrat aus nicht leitendem Aluminiumnitrid oder Aluminiumoxid einzusetzen.
Das dort beschriebene Verfahren ist jedoch auf die speziellen Substrate beschränkt, die nicht transparent sind und auch infolge der Phasenumwandlung nicht transparent werden, da das entstehende Aluminium nicht transparent ist, so dass diese Systeme daher keine optoelektronischen Anwendungen erlauben. Die hier beschriebene erfolgende Phasenumwandlung erfordert zudem eine sehr hohe Laserenergie, was einerseits hohe Ansprüche an den eingesetzten Laser stellt und zusätzlich eine nur geringe Schreibgeschwindigkeit möglich macht.

Überraschenderweise wurde nunmehr festgestellt, dass mittels Lasereinwirkung leitfähige und zugleich transparente Strukturen aus transparenten, leitfähigen Oxiden aus den entsprechenden Grundmaterialien erhalten werden können, wodurch insbesondere eine Kombination von elektrischer mit optischer Strukturierung möglich wird. Das heißt, es können gleichzeitig Leitbahnen und optische Fenster geschrieben werden. Dies ist besonders für transparente Träger wie zum Beispiel Glas oder Polycarbonat für eine Vielzahl von Anwendungen vorteilhaft.

Anders als bei dem vorstehend beschriebenen Verfahren erfolgt bei den erfindungsgemäß eingesetzten Substratmaterialien die Umwandlung bereits mit vergleichsweise niedriger Energie.

Erfindungsgemäß wird somit ein Verfahren zur Herstellung von optischen und elektrischen Strukturen zur Verfügung gestellt, wobei die Strukturen durch Einwirkung von Laser auf ein entsprechendes Substratmaterial erhalten werden.

Zudem betrifft die Erfindung die Verwendung von transparenten, leitfähigen Oxiden und metallischen Systemen zur Strukturierung von leitfähigen und transparenten Bereichen.

Für die vorliegende Erfindung wird unter dem Begriff "Substratmaterial" allgemein das für das erfindungsgemäße Verfahren eingesetzte Material verstanden, unabhängig davon ob es auf einem Träger aufgebracht ist oder nicht.

Gemäß einer bevorzugten Ausführungsform ist das Material jedoch als Schicht oder Schichtsystem aus zwei oder mehreren Schichten auf einen geeigneten Träger aufgebracht.

Transparente leitfähige Dünnschichten aus Oxidmaterialien, den sogenannten TCO-Materialien, sowie Verfahren zu deren Herstellung sind allgemein bekannt. Derartige Schichten werden üblicherweise auf einen Träger beziehungsweise eine Trägerplatte aufgedampft oder aufgesputtert, wobei die Verfahrensbedingungen so gewählt werden, dass hohe Leitfähigkeit und hohe Transparenz erzielt werden, die für die Anwendung dieser Schichten zum Beispiel als Dünnschichtheizung auf transparenten Grundmaterialien erforderlich sind (DE 41 40 415, US-PS 4,942,629).

Beispielsweise weist das häufig zur Herstellung derartiger Schichten eingesetzte InO/Sn (auch als ITO bezeichnet) eine optische Transmission von bis zu 88 % und eine Leitfähigkeit σ = [150 µΩcm]⁻¹ auf.

Erfindungsgemäß wird gerade der entgegengesetzte Weg beschritten, wobei die Verfahrensparameter zur Herstellung von Dünnschichten aus TCO-Materialien derart gewählt werden, dass die erhaltene Schicht möglichst geringe Transmission und einen möglichst hohen spezifischen Widerstand aufweist.

Dies kann auf einfache Art und Weise dadurch geschehen, dass die Abscheidungsparameter wie zum Beispiel Temperatur und Druck entsprechend weit entfernt vom Optimum für die Herstellung von sogenannten TCO-Schichten eingestellt werden.

Eine weitere Möglichkeit zur Herstellung besteht darin, ein System aus TCO-Materialien in Form von Multilagen aufzubauen.
Dabei können die einzelnen Lagen aus den Oxidkomponenten für das auszubildende TCO-Material bestehen, wobei durch Einwirkung des Laserstrahls die Ausbildung des leitfähigen und transparenten TCO-Materials erfolgt. Ein derartiges Multilagensystem kann zum Beispiel aus einzelnen InO und SnO-Schichten aufgebaut sein. Weitere Beispiele sind Schichtsysteme aus In- und SnO-Schichten oder InO- und Sn-Schichten.

Durch Einwirkung von Laserstrahlung auf ausgewählte Bereiche einer derartigen nicht transparenten und nicht leitfähigen. Schicht wird das Material in den der Laserstrahlung ausgesetzten Bereichen in das entsprechende transparente und leitfähige Material umgewandelt.

Im Gegensatz zu der vorstehend beschriebenen Umwandlung von AIN oder Al₂O₃ erfolgt bei den erfindungsgemäß eingesetzten Materialien die Umwandlung zu den leitenden und zugleich transparenten Strukturen bereits bei vergleichsweise geringer Energieeinwirkung.

Da die Anwendung von Laserstrahlung ein exaktes und eng begrenztes Schreiben ermöglicht und zudem die Umwandlung lokal auf die Bereiche auf die die Laserstrahlung einwirkt, beschränkt ist, ermöglicht dieses Verfahren die Herstellung auch von hochaufgelösten transparenten und leitfähigen Strukturen für vielfache Anwendungen auf einfache Art und Weise.

Prinzipiell kann das erfindungsgemäße Verfahren auf alle Materialien angewandt werden, die sich zur Herstellung von TCO-Schichten eignen. Beispiele für geeignete Oxidmaterialien sind das bereits erwähnte Indium-Zinnoxid (ITO) oder ZnO:Al.

Um eine zufriedenstellende Arbeitsweise der erhaltenen Strukturen zu gewährleisten, sollte der Unterschied in der Transmission und des elektrischen Widerstands zwischen den nicht transparenten und nicht leitenden sowie den transparenten und leitenden Bereichen ausreichend hoch gewählt werden.
So sollte die Veränderung in der Transmission mindestens 50 % und die Änderung der Leitfähigkeit mehr als 3, vorzugsweise 10 bis 12 oder mehr Zehnerpotenzen betragen.

Es versteht sich jedoch, dass die Differenz in der Transmission beziehungsweise der Leitfähigkeit von den Anforderungen des jeweiligen Anwendungszweckes abhängt.

Unter dem Begriff "Transparenz" soll erfindungsgemäß im Wesentlichen Transparenz im sichtbaren Wellenlängenbereich von etwa 400 nm bis etwa 750 nm verstanden werden.

Gemäß einer weiteren bevorzugten Ausführungsform können die erfindungsgemäß erhaltenen transparenten leitfähigen Strukturen beziehungsweise Leiterbahnen zusätzlich durch Aufbringen von leitfähigen Materialien verdickt beziehungsweise verstärkt werden. Dies ist von Vorteil für Anwendungen bei denen hohe Ströme fließen und der elektrische Widerstand entsprechend klein sein muss.
Zur Verdickung (Verstärkung) werden dafür vorzugsweise Metalle eingesetzt, zum Beispiel Kupfer.
Diese Metalle können selektiv mittels einem galvanischen Abscheidungsverfahren auf den durch den Laser geschriebenen Strukturen aufgebracht werden, die per se ein hohe elektrische Leitfähigkeit aufweisen.

Durch das Aufbringen zusätzlicher leitfähiger Materialien lässt sich die Dicke der mittels Laser geschriebenen Struktur beziehungsweise Leiterbahn um ein Vielfaches verstärken. Beispielsweise kann eine Leiterbahn aus einem TCO-Material mit einer Dicke von 2 um mittels Abscheidung von Kupferschichten auf eine Dicke von 40 um gebracht werden.

Für bestimmte Anwendungen kann es von Vorteil sein, für die Strukturierung den umgekehrten Weg zu beschreiten, nämlich in ein leitfähiges Substrat oder eine leitfähige Schicht eine entsprechende Strukturierung einzubringen. Die Strukturierung erfolgt hierbei derart, dass nicht die gewünschte Leiterbahn selbst, sondern die Isolation um die Leiterbahn herum geschrieben wird; so dass die Leiterbahn von den umgebenen leitfähigen Material durch nicht leitfähige Bereiche abgetrennt ist.

Das leitfähige Substrat beziehungsweise die leitfähige Schicht kann beispielsweise ein Metall sein, dass durch Einwirkung von Laserstrahlung in einen nicht leitfähigen Zustand übergeht.

Für diese Anwendung besonders geeignete Materialien sind Titan und Niob sowie deren Legierungen, wobei Titan und eine Titanlegierung mit mehr als 80 % Titan besonders bevorzugt sind.

Diese Materialien, die per se nicht transparent sind, gehen durch Einwirkung von Laserstrahlung in einen nicht leitfähigen transparenten Zustand über. Es wird vermutet, dass aufgrund der Einwirkung von Laserstrahlung Sauerstoff in das Material eindiffundiert und die entsprechenden nicht leitfähigen transparenten Oxide ausbildet.

Durch die Einwirkung von Laserstrahlung geeigneter Wellenlänge auf dieses Metall beziehungsweise diese Metalllegierung erfolgt eine lokale Oxidation, wodurch das Material isolierend und transparent wird.

Um einen ausreichenden Transparenzunterschied zwischen den Bereichen ohne Lasereinwirkung und den Bereichen mit Lasereinwirkung zu erzielen, sollte das Substratmaterial in ausreichender Dicke eingesetzt werden, wobei sich eine untere Dicke von etwa 70 nm, vorzugsweise 100 nm als ausreichend erwiesen hat.

Prinzipiell kann diese zweite Ausführungsform für dieselben Anwendungen eingesetzt werden wie vorstehend für die erste Ausführungsform beschrieben. Sie unterscheidet sich gegenüber der ersten Ausführungsform, bei der ein TCO-Material eingesetzt wird, dadurch, dass nicht die gewünschte Leiterbahn selbst, sondern die Isolation um die Leiterbahn herum geschrieben wird.

Aufgrund der Umwandlung des eingesetzten Materials von einem nicht transparenten in den transparenten Zustand können mit dem erfindungsgemäßen Verfahren tief in das Material eindringende Strukturen geschrieben werden, da die gewählte Laserstrahlung transparentes Material durchdringt und damit auf tieferliegende Schichtbereiche einwirken kann, sobald die Umwandlung in den transparenten Zustand an der Oberfläche erfolgt.

Dies ist insbesondere auch von Vorteil für die zweite Ausführungsform, bei der in ein leitfähiges Substrat beziehungsweise eine leitfähige Schicht um die gewünschte Struktur isolierende Bereiche geschrieben werden, da eine ausreichende Isolierung üblicherweise eine entsprechende Umwandlungstiefe erfordert.

Ein weiterer Vorteil der Erfindung ist, dass das behandelte Material in zwei verschiedenen Zuständen vorliegt, die entsprechend unterschiedliches Ätzverhalten aufweisen. Wird also eine Fläche, die das Substratmaterial in den zwei unterschiedlichen Zuständen aufweist in ein Ätzbad getaucht oder einem Trockenätzprozess unterzogen, werden die Bereiche mit unterschiedlichen Zuständen unterschiedlich stark angegriffen und es erfolgt eine Strukturierung ohne das eine aufwendige Fotolithografie eingesetzt werden muss.

Mit dem erfindungsgemäßen Verfahren können nicht nur elektrisch leitfähige Strukturen geschrieben werden, sondern es ermöglicht eine Kombination von elektrischer und zugleich optischer Strukturierung.

Aufgrund seiner einfachen Handhabung ist das Verfahren für viele Anwendungen geeignet. Es lassen sich damit auf einfache Art und Weise auch hochaufgelöste Strukturen ausbilden. Beispielsweise können damit optische Gitter, optisch transparente Fasern, zum Beispiel für Optokoppler, Fenster auf transparenten Substraten einschließlich EMV-Schutz, Leiterbahnen, leitfähige Flächen, zum Beispiel als EMV-Abschirmung, geschrieben werden.

Besonders vorteilhaft lässt sich die Erfindung für die Herstellung von Optokopplern verwenden, da die transparenten Eigenschaften für die Lichtleitung und die elektrische Leitfähigkeit für die elektrische Leitung eingesetzt werden können.
Zudem können aufgrund der hohen Präzision, die mit dem Laser möglich ist, erfindungsgemäß eine exakte Ankopplung der optischen und elektrischen Bahnen erhalten werden, die mit den üblichen fotolithografische Prozessen, wie eingangs beschrieben, nur schwer realisierbar ist.

Die als Ausgangsmaterial eingesetzten TCO-Materialien für die erste Ausführungsform und das elektrisch leitfähige Metall für die zweite Ausführungsform können das Substrat selbst bilden oder auf einem Träger aus einem anderen Material als Schicht oder Schichtsystem in entsprechender Dicke aufgebracht sein.

Als Träger können für die jeweiligen Anwendungen geeignete Materialien eingesetzt werden. Hierbei kann der Träger je nach Bedarf transparent oder nichttransparent gewählt werden. Beispiele für Materialien für den Träger sind Kunststoffe oder ein Glas.

Die Dicke für die Schicht ist ausreichend stark zu wählen, so dass ein ausreichender Kontrast zwischen umgewandelten und nicht umgewandelten Bereichen in den gewünschten . Wellenlängenbereichen, insbesondere für sichtbares Licht, erzielt werden kann.
Andererseits sollte die Schichtdicke nicht ein Maß überschreiten, bei dem keine ausreichend tiefe Strukturierung mehr erzielt werden kann.
Hierbei hängt die konkret zu wählende Schichtdicke einerseits von dem Material und andererseits von der Laserleistung ab. Für TCO-Materialien haben sich hierbei zum Beispiel Schichtdicken in einer Größenordnung von etwa 500 nm und für Titanmaterialien von 70 nm und mehr als geeignet erwiesen. Es versteht sich jedoch, dass die Dicken in Abhängigkeit der jeweiligen Anwendung variieren können.

Prinzipiell kann für das erfindungsgemäße Verfahren jeder Laser eingesetzt werden, der die erwünschte Umwandlung des eingesetzten Ausgangsmaterials induzieren kann. Bei der Auswahl des Lasers ist darauf zu achten, dass der Laser zwar ausreichend Energie zur Umwandlung in das Material einbringt, aber der Energieeintrag nicht so groß ist, dass ein Abbrennen oder Verdampfen beziehungsweise Ablatieren des Materials stattfindet.

Das erfindungsgemäße Verfahren kann beispielsweise mit einem Argonionenlaser oder auch mit einem Nd:YAG-Laser, insbesondere einem Nd:YAG-Laser mit Frequenzverdopplung, durchgeführt werden, wobei Wellenlängen von ungefähr 500 nm bei Energiedichten zwischen 180 und 360 kW/cm² vorteilhaft sind.

## Patentansprüche

1. Verfahren zur Herstellung elektrischer und optischer Strukturen auf einem Substratmaterial durch Einwirkung von Laserstrahlung auf das Substratmaterial.

2. Verfahren nach Anspruch 1,
**dadurch gekennzeichnet,**
**dass** das Substratmaterial ein TCO-Material ist.

3. Verfahren nach Anspruch 2,
**dadurch gekennzeichnet**,
**dass** das TCO-Material Indium-Zinnoxid ist.

4. Verfahren nach Anspruch 2 oder 3,
**dadurch gekennzeichnet,**
**dass** das TCO-Material als Schichtsystem ausgebildet ist.

5. Verfahren nach Anspruch 4,
**dadurch gekennzeichnet,**
**dass** das Schichtsystem aufgebaut ist aus InO- und SnO-Schichten, In- und SnO-Schichten oder InO- und Sn-Schichten.

6. Verfahren nach einem der vorhergehenden Ansprüche,
**dadurch gekennzeichnet**,
**dass** die aus einem TCO-Material gebildete elektrische Leiterbahn durch Aufbringen eines Metalls verstärkt wird.

7. Verfahren nach Anspruch 1,
**dadurch gekennzeichnet,**
**dass** das Substratmaterial ausgewählt ist unter Titan oder dessen Legierungen und Niob oder dessen Legierungen.

8. Verfahren nach Anspruch 7,
**dadurch gekennzeichnet,**
**dass** als Substratmaterial eine Titanlegierung mit mehr als 80 % Titan eingesetzt wird.

9. Verfahren nach einem der vorhergehenden Ansprüche,
**dadurch gekennzeichnet,**
**dass** der Laser ausgewählt ist unter einem Argon-lonenlaser und einem Nd:YAG-Laser.

10. Verfahren nach einem der vorhergehenden Ansprüche,
**dadurch gekennzeichnet,**
**dass** das Substratmaterial nach der Lasereinwirkung einem Ätzverfahren unterzogen wird.

11. Verfahren nach einem der vorhergehenden Ansprüche,
**dadurch gekennzeichnet**,
**dass** das zu strukturierende Substratmaterial als Schicht auf ein Trägermaterial aufgebracht ist.

12. Verfahren nach einem der vorhergehenden Ansprüche,
**dadurch gekennzeichnet**,
**dass** die optischen und elektrischen Strukturen ausgewählt sind unter Leiterbahnen und optischen Fasern.

13. Verfahren nach einem der vorhergehenden Ansprüche,
**dadurch gekennzeichnet,**
**dass** in das Substratmaterial Bereiche geschrieben werden, die für Licht im sichtbaren Wellenlängenbereich transparent sind.

14. Verwendung von transparenten, leitfähigen Oxidschichten und titan- oder niobhaltigen Schichten zur Strukturierung von leitfähigen und transparenten Bereichen.

15. Verwendung nach Anspruch 14,
**dadurch gekennzeichnet,**
**dass** der strukturierte leitfähige, transparente Bereich eine optisch transparente Faser ist.

16. Verwendung nach Anspruch 14,
**dadurch gekennzeichnet**,
**dass** durch die Strukturierung Leiterbahnen und/oder leitfähige Flächen ausgebildet werden.
